# EUROPÄISCHE PATENTSCHRIFT

(11) **EP 1 812 970 B1**
(45) Veröffentlichungstag und Bekanntmachung des Hinweises auf die Patenterteilung: **06.11.2019**
(21) Anmeldenummer: 05791836.9
(22) Anmeldetag: 13.09.2005
(51) Int. Cl.: H01L 29/861, H01L 29/872, H01L 29/866, H01L 21/329, H01L 29/66

(54) **HALBLEITEREINRICHTUNG UND VERFAHREN FÜR DEREN HERSTELLUNG**
SEMICONDUCTOR DEVICE AND METHODS FOR THE PRODUCTION THEREOF
DISPOSITIF A SEMI-CONDUCTEURS ET PROCEDES POUR SA PRODUCTION

(30) Priorität: 08.11.2004 DE 102004053760
(43) Veröffentlichungstag der Anmeldung: 01.08.2007
(73) Patentinhaber: ROBERT BOSCH GMBH, 70442 Stuttgart (DE)
(72) Erfinder: GOERLACH, Alfred, 72127 Kusterdingen (DE); QU, Ning, 72770 Reutlingen (DE)
(86) Internationale Anmeldenummer: PCT/EP2005/054538
(87) Internationale Veröffentlichungsnummer: WO 2006/048354

(56) Entgegenhaltungen:
- EP-A- 1 139 433
- EP-A- 1 369 927
- US-A- 4 982 260
- US-A- 6 078 090
- US-A1- 2003 042 538
- US-B1- 6 501 146
- CHANG H-R ET AL: "1200 V, 50 A Trench Oxide PiN Schottky (TOPS) diode" INDUSTRY APPLICATIONS CONFERENCE, 1999. THIRTY-FOURTH IAS ANNUAL MEETING. CONFERENCE RECORD OF THE 1999 IEEE PHOENIX, AZ, USA 3-7 OCT. 1999, PISCATAWAY, NJ, USA,IEEE, US, Bd. 1, 3. Oktober 1999 (1999-10-03), Seiten 353-358, XP010355182 ISBN: 0-7803-5589-X

## Beschreibung

### Stand der Technik

Die Erfindung betrifft eine Halbleitereinrichtung nach dem Oberbegriff des Anspruchs 1, sowie Verfahren für deren Herstellung.

In modernen Kraftfahrzeugen werden immer mehr Funktionen mit elektrischen Bauelementen realisiert. Dadurch entsteht ein immer höherer Bedarf an elektrischer Leistung. Um diesen Bedarf zu decken, muss die Effizienz des Generatorsystems in dem Kraftfahrzeug gesteigert werden. Bis heute werden in der Regel PN-Dioden als Zener-Dioden in dem Generatorsystem des Kraftfahrzeugs eingesetzt. Vorteile der PN-Dioden sind einerseits der niedrige Sperrstrom und andererseits die hohe Robustheit. Der Hauptnachteil ist jedoch die vergleichsweise hohe Flussspannung UF. Bei Raumtemperatur beginnt Strom erst bei einer Flussspannung UF von etwa 0,7 V zu fließen. Unter normalen Betriebsbedingungen, bei denen die Stromdichte etwa 500A/cm2 beträgt, steigt die Flussspannung UF bis über 1V an. Dies führt zu einem Rückgang der Effizienz.

Aufgrund theoretischer Überlegungen könnte die Schottky-Diode als Alternative in Betracht gezogen werden. Eine Schottky-Diode hat nämlich eine deutlich niedrigere Flussspannung als eine PN-Diode. Beispielsweise beträgt die Flussspannung einer Schottky-Diode etwa 0.5V bis 0.6V bei einer Stromdichte von etwa 500A/cm2. Außerdem bietet eine Schottky-Diode als Majoritätsträgerbauelement Vorteile bei schnellem Schaltbetrieb. Soweit bekannt, ist jedoch der Einsatz von Schottky-Dioden in dem Generatorsystem eines Kraftfahrzeugs bisher noch nicht erfolgt. Dies mag auf einige entscheidende Nachteile einer Schottky-Diode zurückzuführen sein, die eine derartige Anwendung eher als ferner liegend erscheinen lassen. Zunächst hat eine Schottky-Diode im Vergleich zu einer PN-Diode einen höheren Sperrstrom. Dieser Sperrstrom ist weiterhin stark abhängig von der Sperrspannung. Schließlich zeigt eine Schottky-Diode eine schlechtere Robustheit, insbesondere bei hohen Temperaturen. Diese Nachteile haben bisher den Einsatz von Schottky-Dioden bei Anwendungen im Kraftfahrzeug verhindert.

Aus T. Sakai, et al, "Experimental investigation of dependence of electrical characteristics on device parameters in Trench MOS Barrier Schottky Diodes", Proceedings of 1998 International Symposium on Power Semiconductors & ICs, Kyoto, pp. 293-296, sowie aus DE 694 28 996 T2 sind bereits Maßnahmen für eine Verbesserung der Eigenschaften von Schottky-Dioden bekannt, die zu der so genannten TMBS (TMBS = Trench-MOS-Barrier-Schottky-Diode) geführt haben. Ein Vorteil einer derartigen TMBS liegt in der möglichen Reduktion des Sperrstroms. Der Sperrstrom fließt dabei hauptsächlich durch eine Quasi-Inversionsschicht der MOS-Struktur der Diode entlang der Oberfläche eines in die Diodenstruktur eingebrachten Grabens. Als Folge davon kann die MOS-Struktur durch die Injektion so genannter "heißer" Ladungsträger von einer n-Epischicht in eine Oxidschicht degradiert und unter besonders widrigen Bedingungen sogar zerstört werden. Da für die Bildung des Inversionskanals eine gewisse Zeit benötigt wird, kann sich die Raumladungszone zu Beginn von schnellen Schaltvorgängen kurzzeitig weiter ausbreiten und infolgedessen die elektrische Feldstärke ansteigen. Dies kann zu einem kurzzeitigen, unerwünschten Betrieb der Diode im Durchbruch führen. Es ist daher wenig ratsam, die hinsichtlich des Sperrstroms verbesserten TMBS als Zener-Dioden einzusetzen und im Durchbruchsbereich zu betreiben.

Aus der US 4,982,260 A1 und der US 6,078,090 A1 sind bereits Schottky-Dioden mit Grabenstrukturen bekannt.

Aus der US- PS 4,982,260 ist eine Halbleitereinrichtung mit einer Kombination von Schottky-Dioden und PiN-Dioden bekannt. Die Halbleitereinrichtung umfasst ein N⁺ -Substrat, auf dem eine N-Schicht angeordnet ist. Diese weist dabei eine Trench-Struktur bzw. eine Gabenstruktur auf. Die Gräben sind zu einem Teil ihrer Tiefe mit P-dotiertem Material aufgefüllt. Das N⁺-Substrat und die N-Schicht tragen jeweils eine Kontaktschicht, die im Bereich der Gräben von der N-Schicht durch eine Oxidschicht getrennt ist. Eine derartige Anordnung stellt eine MOS-Struktur dar. Wie sich die Durchbruchspannung der PiN-Diode im Verhältnis zur Durchbruchspannung der Schottky-Diode verhält wird nicht angegeben.

Aus der EP 1139 433 A1 sind Halbleitereinrichtungen, vorzugsweise Leistungsgleichrichter bekannt, die Kombinationen von PN-Übergängen und Schottkydioden mit Grabenstrukturen zeigen. Die Gräben sind ganz oder teilweise mit dotiertem Halbleitermaterial aufgefüllt. Eine integrierte PN-Diode mit geringerer Durchbruchspannung Spannung als der Durchbruchspannung des Schottkyübergangs wird gezeigt.

Die Druckschrift US-PS 6,501,146 zeigt weitere Halbleiteranordnungen, die Schottky-Dioden umfassen sowie Herstellungsverfahren für solche Halbleiteranordnungen. Die Halbleitereinrichtung umfasst dabei z.B. ein N⁺-Substrat, auf dem eine n-Schicht angeordnet ist, die Gräben aufweist. Dabei sind die Gräben so asugestaltet, dass die Wandungen der Gräben vollständig, die Böden der Gräben aber höchstens teilweise mit einer Oxidschicht abgedeckt sind. In den Gräben sind p-Bereiche vorhanden und das N⁺-Substrat und die n-Schicht tragen Kontaktschichten. Bezüglich der Durchbruchspannungen der einzelnen Bestandteile der Halbleiteranordnung werden keine genauen Angaben gemacht.

### Vorteile der Erfindung

Die Erfindung mit den Merkmalen des Anspruchs 1 bietet insbesondere den Vorteil, dass die Injektion von so genannten "heißen" Ladungsträgern verhindert wird. Dies wird dadurch erreicht, dass die bei einem Durchbruch auftretende hohe Feldstärke nicht in der Nähe der empfindlichen Oxidschicht liegt, weil die Durchbruchsspannung der integrierten PN-Diode niedriger ist als die Durchbruchsspannungen der Schottky Diode und der MOS-Struktur. Die erfindungsgemäß ausgebildete Halbleitereinrichtung zeichnet sich daher durch eine besonders große Robustheit aus, die einen zuverlässigen Einsatz der Halbleitereinrichtung in dem Bordnetz eines Kraftfahrzeugs, insbesondere in dem Generatorsystem des Bordnetzes, ermöglicht. Besonders vorteilhaft ist die Halbleitereinrichtung bei Durchbruchsspannungen in der Größenordnung einiger 10V und bei Stromdichten von einigen hundert A/cm2 betriebssicher einsetzbar. Besonders vorteilhaft umfasst eine erste Ausführungsvariante der Halbleitereinrichtung ein n+ Substrat, auf dem eine n-Schicht angeordnet ist, in welche Gräben eingebracht sind. Die Gräben sind höchstens auf einem Teil ihrer Tiefe mit einem p-dotierten Polysilizum aufgefüllt. Das n+-Substrat und die n-Schicht tragen jeweils eine Kontaktschicht, wobei die Kontaktschicht in dem Bereich der Wandungen der Gräben durch eine Oxidschicht von der n-Schicht getrennt ist. Die erfindungsgemäße Halbleitereinrichtung umfasst ein n+-Substrat, auf dem eine n-Schicht angeordnet ist, in die Gräben eingebracht sind. Die Wandungen der Gräben sind vollständig, die Böden der Gräben aber höchstens teilweise mit einer Oxidschicht abgedeckt. Unterhalb der Gräben liegen in der n-Schicht durch Diffusion erzeugte p-Bereiche. Das n+-Substrat und die n-Schicht tragen Kontaktschichten.

Weitere Vorteile und Ausgestaltungen der Erfindung, sowie vorteilhafte Verfahren für die Herstellung der Halbleitereinrichtungen ergeben sich aus den weiteren Unteransprüchen in Verbindung mit der Beschreibung und den Zeichnungen.

### Zeichnung

Ausführungsbeispiele der Erfindung werden nachfolgend unter Bezug auf die Zeichnung näher erläutert. Dabei zeigt:
- Figur 1: eine herkömmliche TMBS-Diode;
- Figur 2: eine erstes Ausführungsbeispiel einer erfindungsgemäß ausgebildeten Halbleitereinrichtung;
- Figur 3: ein zweites Beispiel einer ist; Halbleitereinrichtung die nicht Teil der Erfindung
- Figur 4: ein Ablaufdiagramm eines ersten Herstellungsverfahrens;
- Figur 5: ein Ablaufdiagramm eines zweiten Herstellungsverfahrens.

### Beschreibung der Ausführungsbeispiele

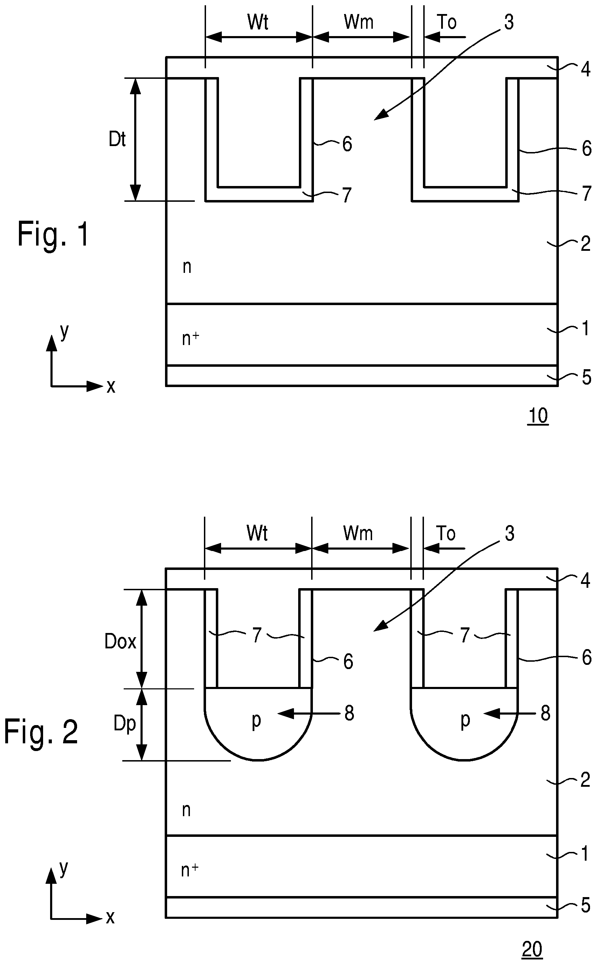

Figur 1 zeigt eine bekannte Halbleitereinrichtung 10, nämlich eine so genannte TMBS-Diode, im Folgenden kurz als "TMBS" bezeichnet. Zunächst wird auf den Aufbau einer derartigen TMBS eingegangen, um im Vergleich dazu, die mit der Erfindung erzielten Vorteile deutlicher herauszustellen. Die TMBS 10 besteht aus einem n⁺-Substrat 1 und einer auf diesem n⁺-Substrat angeordneten n-Schicht 2. In dieser n-Schicht 2 sind, üblicherweise auch als "trenchs" bezeichnete, Gräben 6 eingebracht. Die Grundflächen und die Wandungen der Gräben 6 sind mit einer Oxidschicht 7 abgedeckt. Eine Metallschicht 4 auf der Vorderseite der TMBS 10 dient als Anodenelektrode. Eine Metallschicht 5 auf der Rückseite der TMBS 10 dient als Kathodenelektrode. Elektrisch gesehen ist die TMBS 10 eine Kombination von MOS-Struktur (Metallschicht 4, Oxidschicht 7 und n-Schicht 2) und einer Schottky-Diode. Die Schottky-Barriere liegt dabei zwischen der Metallschicht 4 als Anode und der n-Schicht 2 als Kathode.

In der Flussrichtung fließt ein Strom durch den von den Gräben 6 eingeschlossenen Mesa-Bereich 3 der TMBS 10. Die Gräben 6 selber stehen für den Stromfluss nicht zur Verfügung. Die effektive Fläche für den Stromfluss in der Flussrichtung ist daher bei einer TMBS kleiner als bei einer konventionellen Planar-Schottky-Diode. Der Vorteil einer derartigen TMBS 10 liegt in der Reduktion des Sperrstroms. In der Sperrrichtung bilden sich sowohl bei der MOS-Struktur als auch bei der Schottky-Diode Raumladungszonen aus. Die Raumladungszonen dehnen sich mit steigender Spannung aus und stoßen bei einer Spannung, die kleiner als die Durchbruchspannung der TMBS 10 ist, in der Mitte des Mesa-Bereichs 3 zwischen den benachbarten Gräben 6 zusammen. Dadurch wird der für den hohen Sperrstrom verantwortliche Schottky-Effekt abgeschirmt und der Sperrstrom reduziert. Dieser Abschirmeffekt ist stark von Strukturparametern der TMBS, wie insbesondere Dt (Tiefe des Grabens 6), Wm (Abstand zwischen den Gräben 6), Wt (Breite des Grabens 6), sowie von To (Dicke der Oxidschicht 7) abhängig. Die Abschirmwirkung für den Schottky-Effekt ist bei der TMBS daher deutlich effektiver im Vergleich zu einer JBS (Junction Barrier Schottky Diode) mit diffundierten p-Wannen. Ein entscheidender Nachteil der bekannten TMBS liegt jedoch in der Schwäche der MOS-Struktur. Bei einem Durchbruch entstehen sehr große elektrische Felder innerhalb der Oxidschicht 7 und direkt in der Nähe der Oxidschicht 7 in der n-Schicht 2. Der Sperrstrom fließt hauptsächlich durch die Quasi-Inversionsschicht der MOS-Struktur entlang der Oberfläche der Gräben 6. Als Folge kann die MOS-Struktur durch Injektion "heißer" Ladungsträger von der n-Schicht 2 in die Oxidschicht 7 degradiert und unter bestimmten widrigen Betriebsbedingungen sogar zerstört werden. Da zur Bildung des Inversionskanals eine gewisse Zeit benötigt wird (deep depletion), kann sich die Raumladungszone zu Beginn von schnellen Schaltvorgängen kurzzeitig weiter ausbreiten und deshalb die elektrische Feldstärke weiter ansteigen. Dies kann zu einem kurzzeitigen, unerwünschten Betrieb im Durchbruch führen. Es ist daher wenig ratsam, eine TMBS als Zener-Diode einzusetzen und im Durchbruchsbereich zu betreiben.

Die Erfindung vermeidet dieses Problem dadurch, dass in die TMBS eine PN-Diode integriert wird, die als Klammerelement dient. Im Folgenden wird die erfindungsgemäß ausgestaltete Halbleitereinrichtung 20 beschrieben, die auch kurz als TMBS-PN bezeichnet werden kann. Die Auslegung der p-Bereiche sorgt bei dieser Halbleitereinrichtung 20 dafür, dass die Durchbruchspannung BV_pn der PN-Diode niedriger ist als die Durchbruchspannung BV_schottky der Schottky-Diode und die Durchbruchspannung BV_mos der MOS-Struktur. Weiterhin ist dafür gesorgt, dass die bei einem Durchbruch auftretende große Feldstärke nicht in der Nähe einer Oxidschicht liegt und daher keine Injektion von heißen Ladungsträgern zu befürchten ist. Außerdem fließt der Sperrstrom hauptsächlich durch die PN-Diode statt durch die Inversionsschicht der MOS-Struktur. Diese Eigenschaften verleihen der Halbleitereinrichtung 20 eine große Robustheit. Sie eignet sich daher besonders als Zener-Diode für einen Einsatz in dem Bordnetz eines Kraftfahrzeugs, insbesondere in Verbindung mit dem Generatorsystem eines Kraftfahrzeugs.

Im Folgenden wird unter Bezug auf Figur 2 ein erstes Ausführungsbeispiel einer erfindungsgemäß ausgebildeten Halbleitereinrichtung beschrieben.

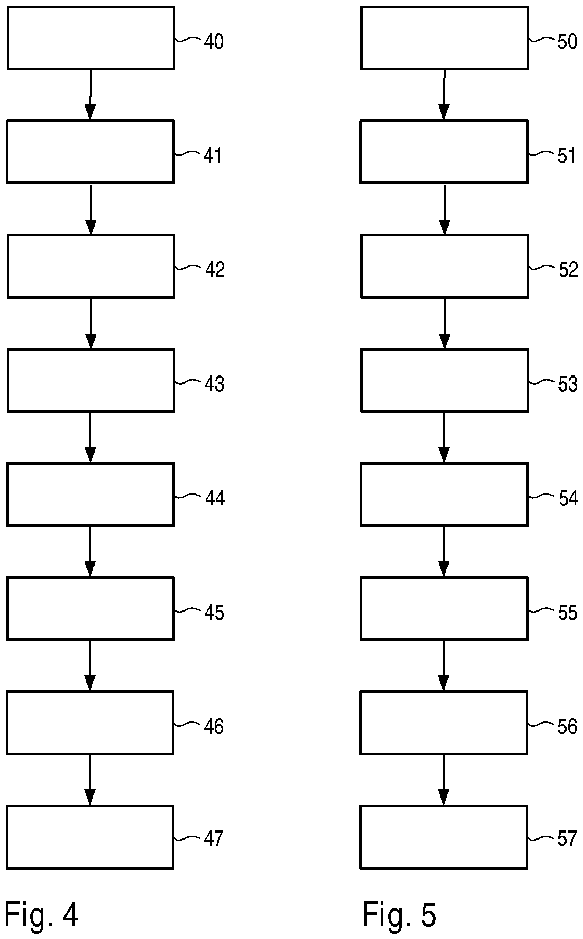

Die Halbleitereinrichtung 20 umfasst p-dotierte Bereiche 8 aus Poly-Si in dem unteren Bereich der Gräben 6. Vorzugsweise sind diese Bereiche 8 wannenförmig ausgebildet. Im Einzelnen besteht die Halbleitereinrichtung 20 aus einem n+-Substrat 1, einer auf diesem Substrat 1 angeordneten n-Schicht 2, sowie in die n-Schicht 2 eingebrachten Gräben (trenchs) 6. Vorzugsweise sind mindestens zwei Gräben 6 vorgesehen. Die Gräben 6 können in einer bevorzugten Ausführungsvariante der Erfindung als in der n-Schicht 2, bevorzugt parallel zueinander verlaufende Streifen ausgebildet sein. In anderen Ausführungsvarianten der Erfindung können die Gräben 6 auch inselförmig in der n-Schicht 2 angeordnet sein. Die Querschnitte dieser inselförmig angeordneten Gräben 6 können dabei beliebig gestaltet sein. Im Sinne einer guten Reproduzierbarkeit und leichten Fertigung sind die Inseln jedoch bevorzugt von einem regelmäßigen Querschnitt, also beispielsweise kreisförmig, sechseckig oder dergleichen. Die Gräben 6 werden vorzugsweise durch einen Ätzvorgang erzeugt, der in dem Ätzbereich das Material der n-Schicht 2 abträgt. Die Grundflächen und die Wandungen der Gräben 6 sind mit einer Oxidschicht 7 abgedeckt. Kontaktschichten 4, 5 sind an der Vorderseite der Halbleitereinrichtung 20 als Anodenelektrode (4) und an der Rückseite als Kathodenelektrode (5) angeordnet. Eine Oxidschicht 7 befindet sich zwischen den Seitenwänden der Gräben 6 und der Metallschicht 4. Der untere Bereich 8 der Gräben 6 wird mit p-dotiertem Poly-Si ausgefüllt. Dabei werden die p-Bereiche 8 so ausgelegt, dass zwischen der n-Schicht 2 und den p-Bereichen 8 keine Ladungskompensation auftritt. In einer Ausführungsvariante der Erfindung kann insbesondere die Kontaktschicht 4 auch aus zwei übereinander liegenden Metallschichten bestehen. Der Übersichtlichkeit wegen ist dies in Figur 2 nicht eingezeichnet. Mit Dox ist der mit einer Oxidschicht 7 bedeckte Teil der Tiefe der Gräben 6 bezeichnet. Mit Dp ist der mit einem p-Bereich ausgefüllte Anteil der Tiefe der Gräben 6 bezeichnet. Mit Wm ist der Abstand der Gräben 6 bezeichnet. Mit Wt ist die Breite der Gräben 6 bzw. der in den Gräben 6 angeordneten p-Bereiche bezeichnet. Mit To ist die Dicke der Oxidschicht 7 bezeichnet. Die erfindungsgemäß ausgestaltete Halbleitereinrichtung 20 kann zweckmäßig auf folgende Weise hergestellt werden. In diesem Zusammenhang wird auch auf das in Figur 4 dargestellte Ablaufdiagramm verwiesen. Ausgegangen wird von einem n+-Substrat 1 (Schritt 40). Auf dieses n+-Substrat 1 wird eine n-Schicht 2 aufgebracht (Schritt 41). Dies erfolgt vorzugsweise durch ein Epitaxieverfahren. In dem nächsten Schritt 42 werden die Gräben 6 in die n-Schicht 2 geätzt. Anschließend werden die Gräben 6 mit p-dotiertem Poly-Si aufgefüllt (Schritt 43). In einem folgenden Ätzverfahren wird das p-dotierte Poly-Si in den Gräben 6 soweit abgeätzt, dass nur noch ein Anteil Dp der Tiefe der Gräben 6 mit p-dotiertem Poly-Si ausgefüllt ist (Schritt 44). In einem nächsten Schritt 45 werden die Böden und Wandungen der Gräben 6 mit einer Oxidschicht bedeckt. In einem folgenden Ätzschritt (Schritt 46) wird die Oxidschicht von den Böden der Gräben 6 wieder entfernt, so dass nur noch die Wände der Gräben 6 mit einer Oxidschicht 7 bedeckt sind. In einem weiteren Schritt 47 werden vorzugsweise aus Metall bestehende Kontaktschichten 4 und 5 auf die Vorder- und Rückseite der Halbleitereinrichtung 20 aufgebracht.

Im Folgenden wird die Funktionsweise der Halbleitereinrichtung 20 erläutert. Elektrisch gesehen ist die erfindungsgemäß ausgestaltete Halbleitereinrichtung 20 eine Kombination einer MOS-Struktur (Kontaktschicht 4, Oxidschicht 7 und n-Schicht 2), einer Schottky-Diode (Schottky-Barriere zwischen der Kontaktschicht 4 als Anode und der n-Schicht 2 als Kathode) und einer PN-Diode (PN-Übergang zwischen den p-Bereichen 8 als Anode und der n-Schicht 2 als Kathode) .Bei der Halbleitereinrichtung 20 fließt der Strom in Flussrichtung, wie bei der konventionellen TMBS 10, nur durch die Schottky-Diode. In der Sperrrichtung bilden sich sowohl bei der MOS-Struktur als auch bei der Schottky-Diode und bei der PN-Diode Raumladungszonen aus. Die Raumladungszonen dehnen sich mit steigender Spannung aus und stoßen bei einer Spannung, die kleiner als die Durchbruchspannung der Halbleitereinrichtung 20 ist, in der Mitte des Mesa-Bereichs 3 zwischen den benachbarten Gräben 6 zusammen. Dadurch wird der für einen hohen Sperrstrom verantwortliche Schottky-Effekt abgeschirmt und somit der Sperrstrom reduziert. Dieser Abschirmeffekt ist stark von Strukturparametern, wie Dox (Anteil der Tiefe des Grabens 6 mit Oxidschicht), Wm (Abstand zwischen den Gräben), Wt (Breite des Grabens 6 bzw. der p-Bereiche 8), Dp (Anteil der Tiefe des Grabens 6 mit p-dotiertem Poly-Si), sowie To (Dicke der Oxidschicht) abhängig, und kann daher durch geeignete Bemessung der genannten Strukturparameter vorteilhaft beeinflusst werden. Die Halbleitereinrichtung 20 verfügt über eine ähnliche Abschirmwirkung für den Schottky-Effekt wie die herkömmliche TMBS 10, bietet aber zusätzlich eine hohe Robustheit durch die Klammerfunktion. Die Durchbruchspannung BV_pn der PN-Diode wird dabei vorteilhaft derart ausgelegt, dass sie niedriger ist als die Durchbruchspannung BV_schottky der Schottky-Diode und die Durchbruchspannung BV_mos der MOS-Struktur. Weiterhin ist dafür gesorgt, dass der Durchbruch am Boden der Gräben 6 stattfindet. Im Durchbruchsbetrieb fließt der Sperrstrom dann nur durch die PN-Übergänge und nicht durch die Inversionsschicht der MOS-Struktur wie bei der herkömmlichen TMBS 10. Die erfindungsgemäß ausgestaltete Halbleitereinrichtung 20 verfügt damit über eine ähnliche Robustheit wie eine PN-Diode. Außerdem braucht man bei der Halbleitereinrichtung 20 die Injektion von "heißen" Ladungsträgern nicht zu befürchten, da sich die hohe Feldstärke beim Durchbruch nicht in der Nähe der MOS-Struktur befindet. Infolgedessen ist die Halbleitereinrichtung 20 besonders gut als Zener-Diode für einen Einsatz in dem Bordnetz eines Kraftfahrzeugs, insbesondere in dem Generatorsystem eines Kraftfahrzeugs, geeignet.

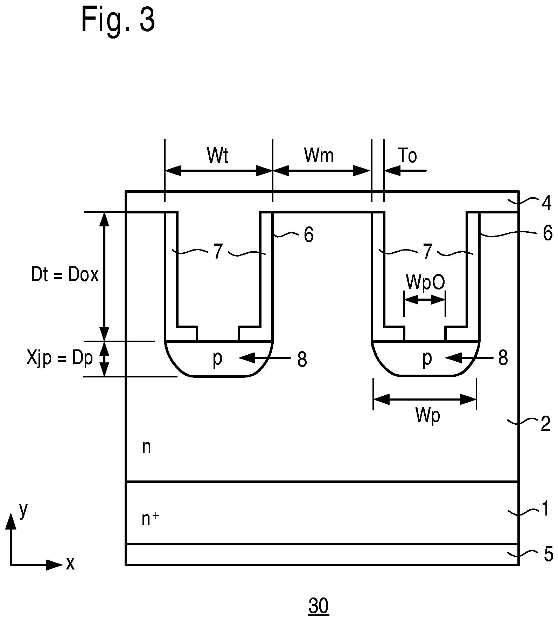

Eine weitere Variante die als Beispiel dient, wird nun im Folgenden unter Bezug auf Figur 3 erläutert. Bei dieser Halbleitereinrichtung 30 sind die p-Bereiche 8 unterhalb der Gräben 6 durch Diffusion hergestellt. Die Halbleitereinrichtung 30 umfasst wiederum ein n+-Substrat 1. Auf diesem Substrat 1 ist eine n-Schicht 2 angeordnet. In die n-Schicht 2 sind mindestens zwei Gräben 6 eingebracht. Auf Vorder- und Rückseite trägt die Halbleitereinrichtung 30 Kontaktschichten 4 bzw. 5. Die Wände der Gräben 6 und ein Teil ihrer Böden sind mit einer Oxidschicht 7 bedeckt. Unterhalb der Gräben 6 sind durch Diffusion eines p-Dotierstoffs, vorzugsweise Bor, erzeugte p-Bereiche 8 angeordnet. Diese bilden mit der n-Schicht 2 eine PN-Diode. Zusätzlich zu den schon in Figur 2 bezeichneten Strukturparametern sind in Figur 3 noch folgende Strukturparameter neu aufgenommen. Mit Wp0 ist die Breite der p-Bereiche 8 auf Maske bezeichnet. Mit Xjp ist die Eindringtiefe der Diffusion in die n-Schicht 2 bezeichnet. Bei der Bemessung der p-Bereiche 8 muss sichergestellt werden, dass im Durchbruchsbetrieb der Durchbruch an dem pn-Übergang 8/2 stattfindet und dass die Durchbruchsspannung der Halbleitereinrichtung 30 von der PN-Diode bestimmt wird. Auch diese Variante die als Beispiel dient, die Erfindung zu verstehen, verfügt über ähnlich vorteilhafte Eigenschaften, insbesondere über eine vergleichbare Robustheit wie die unter Bezug auf Figur 2 beschriebene erste Ausführungsvariante der Erfindung. Ein Vorteil dieser zweiten Variante die als Beispiel dient, die Erfindung zu verstehen, ist im Vergleich zu der ersten Ausführungsvariante (Figur 2) insbesondere darin zu sehen, dass hier das Ausfüllen der Gräben 6 mit p-dotiertem Poly-Si und das anschließende Zurückätzen des p-dotierten Poly-Si entfällt. Die Bor-Belegung, kombiniert mit p-Diffusion, gehört zu den einfacheren Prozessschritten. Im Folgenden wird ein vorteilhaftes Verfahren zur Herstellung der Halbleitereinrichtung 30 (Beispielsvariante nach Figur 3) beschrieben, wobei auch auf das Ablaufdiagramm in Figur 5 Bezug genommen wird. Ausgegangen wird wiederum von einem n+-Substrat 1 (Schritt 50), auf das eine n-Schicht 2, vorzugsweise durch Epitaxie, aufgebracht wird (Schritt 51). Durch ein Ätzverfahren werden Gräben 6 in die n-Schicht 2 eingebracht (Schritt 52). Anschließend werden die Böden und Seitenwände der Gräben 6 mit einer Oxidschicht bedeckt (Schritt 53). In einem anschließenden Ätzschritt (Schritt 54) wird die die Böden der Gräben 6 bedeckende Oxidschicht teilweise entfernt. Auf diese Weise entsteht eine Maske der Breite Wp0 für den anschließenden Diffusionsprozess. Dazu wird zunächst der von der Oxidschicht befreite Bereich der Gräben 6 mit einem p-Dotierstoff, vorzugsweise Bor, belegt (Schritt 55). Dies erfolgt vorzugsweise durch Abscheidung aus der Gasphase oder durch Ionenimplantation. Anschließend wird der Diffusionsprozess durchgeführt (Schritt 56), bei dem Bor in die n-Schicht 2 diffundiert und die p-Bereiche 8 bildet. Abschließend werden wiederum Kontaktschichten 4 und 5 auf Vorder- und Rückseite der Halbleitereinrichtung 30 aufgebracht (Schritt 57), nachdem zuvor noch ein Foto- und Ätzprozess für die Öffnung des Kontaktbereichs wp0 stattgefunden hat.

In vorteilhaften weiteren Ausgestaltungen der Erfindung kann die Ausführnungsvariante 1 im Randbereich noch zusätzliche Strukturen zur Reduktion der Randfeldstärke aufweisen. Dies können z.B. niedrig dotierte p-Bereiche, Feldplatten oder ähnliche Strukturen sein.

Wie bereits erwähnt, eignet sich die erfindungsgemäß ausgestalteten Halbleitereinrichtungen 20 infolge ihrer Robustheit, besonders als Zener-Dioden in Verbindung mit einem Bordnetz eines Kraftfahrzeugs, insbesondere für den Einsatz in dem Generatorsystem eines Kraftfahrzeugs. Dazu verfügt die Halbleitereinrichtung 20 zweckmäßig über eine zwischen 12V und 30V, insbesondere zwischen 15V und 25V liegende Durchbruchsspannung. Besonders vorteilhaft ist die Halbleitereinrichtung 20 im Sperrbetrieb mit einer hohen Stromdichte in der Größenordnung einiger hundert A/cm², insbesondere 400 A/cm² bis etwa 600 A/cm², betreibbar.

### Bezugszeichenliste

- 1: n+-Substrat
- 2: n dotierte Schicht
- 3: Mesa-Bereich
- 4: Kontaktschicht
- 5: Kontaktschicht
- 6: Graben
- 7: Oxidschicht
- 40: Schritt
- 41: Schritt
- 42: Schritt
- 43: Schritt
- 44: Schritt
- 45: Schritt
- 46: Schritt
- 47: Schritt
- 50: Schritt
- 51: Schritt
- 52: Schritt
- 53: Schritt
- 54: Schritt
- 55: Schritt
- 56: Schritt
- 57: Schritt
- BV_mos: Durchbruchsspannung der MOS-Struktur
- BV_pn: Durchbruchsspannung der PN-Diode
- BV_schottky: Durchbruchsspannung der Schottky-Diode
- Dox: Anteil der Tiefe der Gräben mit Oxidschicht
- Dp: Anteil der Tiefe der Gräben mit Si oder Poly-Si
- Dt: Tiefe der Gräben
- To: Dicke der Oxidschicht
- Wm: Abstand zwischen den Gräben
- Wt: Breite der Gräben
- Wp0: Breite der p-Bereiche auf Maske

## Patentansprüche

1. Halbleitereinrichtung (20,30) umfassend eine Trench-MOS-Barrier-Schottky-Diode mit integrierter PN-Diode als Klammerelement, die eine Kombination aus Schottky-Diode, MOS-Struktur und PN-Diode umfasst, **dadurch gekennzeichnet, dass** die Halbleitereinrichtung (20) ein n+-Substrat (1) umfasst, dass auf dem n+-Substrat eine n-Schicht (2) angeordnet ist, dass in der n-Schicht (2) Gräben (6) angeordnet sind, dass die Gräben (6) höchstens auf einem Teil ihrer Tiefe mit einem p-dotierten Poly-Si (8) aufgefüllt sind, und
dass das n+-Substrat (1) eine Kontaktschicht (5) als Kathodenschicht (5) und die n-Schicht (2) eine Kontaktschicht (4) als Anodenschicht (4) tragen, wobei die Anodenschicht (4) in dem Bereich der Wandungen der Gräben (6) durch eine Oxidschicht (7) von der n-Schicht (2) getrennt und so eine MOS-Struktur bildet ist, wobei die Anodenschicht (4) einen Ohmschen Kontakt zu dem p-dotierten Poly-Si (8), eine Schottky-Diode zu der n-Schicht (2) bildet und gleichzeitig für die MOS-Struktur als Gateelektrode dient, wobei das p-dotierte Poly-Si (8) mit der n-Schicht (2) eine PN-Diode bildet, und dass die Durchbruchsspannung (BV_pn) der PN-Diode niedriger ist als die Durchbruchsspannungen (BV_mos, BV_schottky) der MOS-Struktur und der Schottky-Diode.

2. Halbleitereinrichtung (20) nach Anspruch1, **dadurch gekennzeichnet, dass** diese im Sperrbetrieb mit einer hohen Stromdichte in der Größenordnung einiger hundert A/cm², insbesondere 400 A/cm² bis etwa 600 A/cm², betreibbar ist.

3. Halbleitereinrichtung (20) nach einem der vorhergehenden Ansprüche, **dadurch gekennzeichnet, dass** die Kontaktschichten (4,5) aus Metall bestehen.

4. Halbleitereinrichtung (20) nach einem der vorhergehenden Ansprüche, **dadurch gekennzeichnet, dass** die Kontaktschichten (4,5) mehrschichtig ausgebildet sind.

5. Halbleitereinrichtung (20) nach einem der vorhergehenden Ansprüche, **dadurch gekennzeichnet, dass** die Gräben (6) einen U-förmigen oder rechteckigen Querschnitt aufweisen.

6. Halbleitereinrichtung (20) nach einem der vorhergehenden Ansprüche, **dadurch gekennzeichnet, dass** sie derart ausgebildet ist, dass im Falle eines Durchbruchs der PN-Diode der Durchbruch vorzugsweise in dem Bereich des Bodens der Gräben (6) stattfindet.

7. Halbleitereinrichtung (20) nach einem der vorhergehenden Ansprüche 1 bis 4, **dadurch gekennzeichnet, dass** die von der n-Schicht (2) getragene Kontaktschicht (4) die Gräben (6) vollständig ausfüllt.

8. Halbleitereinrichtung (20) nach einem der vorhergehenden Ansprüche, **dadurch gekennzeichnet, dass** die Gräben (6) streifen- oder inselförmig ausgebildet sind.

9. Halbleitereinrichtung (20) nach einem der vorhergehenden Ansprüche, **dadurch gekennzeichnet, dass** sie eine Durchbruchsspannung zwischen 10V und 30V, insbesondere zwischen 15V und 25V, aufweist.

10. Verfahren für die Herstellung einer Halbleitereinrichtung (20) nach einem der vorhergehenden Ansprüche, **dadurch gekennzeichnet, dass** auf ein n+-Substrat eine n-Schicht aufgebracht wird, dass in die n-Schicht (2) Gräben (6) eingebracht werden, dass die Gräben (6) mit einer Oxidschicht (7) abgedeckt werden, dass die Oxidschicht von dem Boden der Gräben und zusätzlich von einem Teil der Wandungen der Gräben (6) entfernt wird, dass der von der Oxidschicht (7) befreite Teil der Gräben (6) zwecks Bildung von p-Bereichen (8) mit p-dotiertem Poly-Si aufgefüllt wird, und dass das n+-Substrat (1) und die n-Schicht (2) mit Kontaktschichten (4,5) belegt werden, wobei die nicht mit p-dotiertem Poly-Si (8) angefüllten Bereiche der Gräben (6) vollständig mit dem Material der Kontaktschicht (4) aufgefüllt werden.

## Claims

1. Semiconductor device (20, 30) comprising a trench MOS barrier Schottky diode with integrated PN diode as clamp element, which comprises a combination of Schottky diode, MOS structure and PN diode, **characterized in that** the semiconductor device (20) comprises an n+-type substrate (1), **in that** an n-type layer (2) is arranged on the n+-type substrate, **in that** trenches (6) are arranged in the n-type layer (2), **in that** the trenches (6) are filled with a p-doped poly-Si (8) at most over a part of their depth, and **in that** the n+-type substrate (1) bears a contact layer (5) as cathode layer (5) and the n-type layer (2) bears a contact layer (4) as anode layer (4), wherein the anode layer (4) is separated from the n-type layer (2) by an oxide layer (7) in the region of the walls of the trenches (6) and an MOS structure is thus formed, wherein the anode layer (4) forms an ohmic contact with the p-doped poly-Si (8), a Schottky diode with respect to the n-type layer (2), and at the same time serves as gate electrode for the MOS structure, wherein the p-doped poly-Si (8) together with the n-type layer (2) forms a PN diode, and **in that** the breakdown voltage (BV_pn) of the PN diode is lower than the breakdown voltages (BV_mos, BV_schottky) of the MOS structure and the Schottky diode.

2. Semiconductor device (20) according to Claim 1, **characterized in that** it is operable in off-state operation with a high current density of the order of magnitude of a few hundred A/cm², in particular 400 A/cm² to approximately 600 A/cm².

3. Semiconductor device (20) according to either of the preceding claims, **characterized in that** the contact layers (4, 5) consist of metal.

4. Semiconductor device (20) according to any of the preceding claims, **characterized in that** the contact layers (4, 5) are embodied in multilayered fashion.

5. Semiconductor device (20) according to any of the preceding claims, **characterized in that** the trenches (6) have a U-shaped or rectangular cross section.

6. Semiconductor device (20) according to any of the preceding claims, **characterized in that** it is embodied in such a way that in the case of a breakdown of the PN diode, the breakdown preferably takes place in the region of the bottom of the trenches (6).

7. Semiconductor device (20) according to any of the preceding claims 1 to 4, **characterized in that** the contact layer (4) borne by the n-type layer (2) completely fills the trenches (6).

8. Semiconductor device (20) according to any of the preceding claims, **characterized in that** the trenches (6) are embodied in strip-shaped or insular fashion.

9. Semiconductor device (20) according to any of the preceding claims, **characterized in that** it has a breakdown voltage of between 10 V and 30 V, in particular between 15 V and 25 V.

10. Method for producing a semiconductor device (20) according to any of the preceding claims, **characterized in that** an n-type layer is applied to an n+-type substrate, **in that** trenches (6) are introduced into the n-type layer (2), **in that** the trenches (6) are covered with an oxide layer (7), **in that** the oxide layer is removed from the bottom of the trenches and additionally from a portion of the walls of the trenches (6), **in that** the portion of the trenches (6) that is freed of the oxide layer (7) is filled with p-doped poly-Si for the purpose of forming p-type regions (8), and **in that** the n+-type substrate (1) and the n-type layer (2) are covered with contact layers (4, 5), wherein those regions of the trenches (6) which are not filled with p-doped poly-Si (8) are completely filled with the material of the contact layer (4).

## Revendications

1. Dispositif à semi-conducteur (20, 30) comprenant une diode Schottky à barrière MOS à tranchées comportant une diode PN intégrée en tant qu'élément de blocage, comprenant une combinaison constituée d'une diode Schottky, d'une structure MOS et d'une diode PN, **caractérisé en ce que** le dispositif à semi-conducteur (20) comprend un substrat n+ (1), **en ce qu'**une couche n (2) est disposée sur le substrat n+, **en ce que** des tranchées (6) sont disposées dans la couche n (2), **en ce que** les tranchées (6) sont remplies d'un poly-Si dopé p (8) au plus sur une partie de leur profondeur, et **en ce que** le substrat n+ (1) porte une couche de contact (5) en tant que couche cathodique (5) et la couche n (2) porte une couche de contact (4) en tant que couche anodique (4), dans lequel la couche anodique (4) est séparée de la couche n (2) par une couche d'oxyde (7) dans la région des parois des tranchées (6) et forme ainsi une structure MOS, dans lequel la couche anodique (4) forme un contact ohmique avec le poly-Si dopé p (8), une diode Schottky avec la couche n (2), et sert simultanément d'électrode de grille pour la structure MOS,
dans lequel le poly-Si dopé p (8) forme une diode PN avec la couche n (2), et **en ce que** la tension de claquage (BV_pn) de la diode PN est inférieure aux tensions de claquage (BV_mos, BV_schottky) de la structure MOS et de la diode Schottky.

2. Dispositif à semi-conducteur (20) selon la revendication 1, **caractérisé en ce qu'**il peut fonctionner en mode de blocage avec une densité de courant élevée de l'ordre de quelques centaines A/cm², en particulier 400 A/cm², jusqu'à environ 600 A/cm².

3. Dispositif à semi-conducteur (20) selon l'une des revendications précédentes, **caractérisé en ce que** les couches de contact (4, 5) sont constituées de métal.

4. Dispositif à semi-conducteur (20) selon l'une des revendications précédentes, **caractérisé en ce que** les couches de contact (4, 5) sont réalisées sous forme multicouche.

5. Dispositif à semi-conducteur (20) selon l'une des revendications précédentes, **caractérisé en ce que** les tranchées (6) présentent une section transversale en U ou rectangulaire.

6. Dispositif à semi-conducteur (20) selon l'une des revendications précédentes, **caractérisé en ce qu'**il est réalisé de manière à ce qu'en cas de claquage de la diode PN, le claquage ait lieu de préférence dans la région du fond des tranchées (6).

7. Dispositif à semi-conducteur (20) selon l'une des revendications 1 à 4 précédentes, **caractérisé en ce que** la couche de contact (4) portée par la couche n (2) remplit complètement les tranchées (6).

8. Dispositif à semi-conducteur (20) selon l'une des revendications précédentes, **caractérisé en ce que** les tranchées (6) réalisées sous la forme de bandes ou d'îlots.

9. Dispositif à semi-conducteur (20) selon l'une des revendications précédentes, **caractérisé en ce qu'**il présente une tension de claquage comprise entre 10V et 30V, en particulier entre 15V et 25V.

10. Procédé de fabrication d'un dispositif à semi-conducteur (20) selon l'une des revendications précédentes, **caractérisé en ce qu'**une couche n est appliquée sur un substrat n+, **en ce que** des tranchées (6) sont introduites dans la couche n (2), **en ce que** les tranchées (6) sont recouvertes d'une couche d'oxyde (7), **en ce que** la couche d'oxyde est enlevée du fond des tranchées ainsi que d'une partie des parois des tranchées (6), **en ce que** la partie des tranchées (6) libérée de la couche d'oxyde (7) est remplie de poly-Si dopé p pour former des régions p (8), et **en ce que** le substrat n+ (1) et la couche n (2) sont recouverts de couches de contact (4, 5), dans lequel les régions des tranchées (6) non remplies de Poly-Si dopé p (8) sont complètement remplies du matériau de la couche de contact (4).
